# EUROPÄISCHE PATENTSCHRIFT

(11) **EP 0 671 118 B1**
(45) Veröffentlichungstag und Bekanntmachung des Hinweises auf die Patenterteilung: **12.02.1997**
(21) Anmeldenummer: 94900048.3
(22) Anmeldetag: 20.11.1993
(51) Int. Cl.: H05K 13/04

(54) **ANLANGEN SOWIE VERFAHREN ZUR AUTOMATISCHEN ENTSTÜCKUNG**
PROCESS AND APPARATUS FOR THE AUTOMATIC REMOVAL OF COMPONENTS
PROCEDE ET APPAREILLAGE D'ENLEVEMENT AUTOMATIQUE DE COMPOSANTS

(30) Priorität: 26.11.1992 DE 4239642; 22.09.1993 DE 4332236
(43) Veröffentlichungstag der Anmeldung: 13.09.1995
(73) Patentinhaber: F.E.S. USED ELECTRONICS ELEKTRONISCHE GEBRAUCHTGERÄTE GMBH, D-63755 Alzenau (DE)
(72) Erfinder: ENGLERT, Klaus, D-63755 Alzenau (DE)
(74) Vertreter: Pöhner, Wilfried Anton, Dr.
(86) Internationale Anmeldenummer: DE9301104
(87) Internationale Veröffentlichungsnummer: WO9413124

(56) Entgegenhaltungen:
- EP-A- 0 355 377
- DE-A- 3 935 424

## Beschreibung

Die Erfindung bezieht sich auf zwei Anlagen zur automatischen Entstückung von mit elektronischen Bauelementen bestückten Leiterplatten sowie ein Verfahren unter Verwendung einer derartigen Anlage.

Die heute gängigen Verfahren zum Entsorgen von defekten oder aus veralteten Geräten stammenden bestückten Leiterplatten sind das Deponieren und das Verbrennen. Der hohe Anteil an Gefahr- und Wertstoffen macht sie jedoch für eine Demontage besonders interessant. Es ist daher zweckmäßig, die auf den Leiterplatten vorhandenen Bauelemente in wiederverwendbare, verwertbare und für den Sondermüll bestimmte Bauelemente zu trennen. Ein manuelles Entstücken der Platinen ist wegen der hohen Arbeitskosten nicht wirtschaftlich, während eine Anlage, die die Bauelemente automatisch entstückt, bisher nicht bekannt ist.

Beispielsweise ist in der Zeitschrift Surface Mount Technology, Ausg. 8 (1992), Seite 63 in der mittleren und rechten Spalte dargelegt, daß der Elektronikschrott nicht wiederzuverwerten ist, sondern stofflich, d.h. thermisch oder chemisch aufbereitet werden muß.

Aus der DE 39 35 424 A1 ist ein Zeilenabtastgerät zum Erfassen hervorstehender Muster bekannt. Dazu wird ein Laserstrahl über mehrere Spiegel und Linsen auf eine Ebene abgelenkt, so daß er senkrecht auf dieser Ebene auftrifft. Der reflektierte Laserstrahl wird von einem Strahlenpunktpostitionsderektor ausgewertet. Dieses Gerät kann insbesondere zur Kontrolle von Schaltungsplatinen verwendet werden, indem die vom Strahlenpunktpositions-detektor erfaßten Muster mit Sollwerten verglichen wird. Ein solches Gerät kann eine Platinen-entstückung nicht selbständig durchführen, da es nicht über Werkzeuge zur Entstückung verfügt. Außerdem besitzt es nicht die Fähigkeit, die Bauteile zu klassifizieren und somit zwischen wiederverwendbaren, verwertbaren und für den Sondermüll bestimmten Bauelementen zu unter-scheiden. Der weiterer Nachteil dieses Geräts ist, daß es einer aufwendigen Spiegel- und Linsen-anordnung bedarf.

Hiervon ausgehend liegt der Erfindung das Problem zugrunde, mit elektronischen Bauelementen bestückte Leiterplatten automatisch zu entstücken und die noch verwendbaren Bauelemente wiederzugewinnen.

Im folgenden werden zwei alternative Lösungsmöglichkeiten vorgeschlagen, wovon eine mit Licht und eine mit Infrarotstrahlung arbeitet.

Erfindungsgemäß wird diese Aufgabe gelöst durch eine Beleuchtungseinrichtung zur Ausleuchtung der Leiterplatten, einen optischen Sensor, ein Bild-verarbeitungssystem und eine Vorrichtung zur Entnahme der Bauelemente, wobei das Bild-verarbeitungssystem in der Weise aufgebaut ist, daß es aus dem vom optischen Sensor gelieferten Aus-gangssignal die Koordinaten der Konturen und vorzugsweise die Typen der Bauelemente erkennt und die Vorrichtung zur Entnahme der Bauelemente steuert.

Der Kerngedanke der Erfindung ist der Aufbau einer Anlage, durch die eine mit elektronischen Bauelementen bestückte Leiterplatte in einem ersten Arbeitsschritt beleuchtet und von einem optischen Sensor aufgenommen wird. Die Beleuchtung erfolgt zweckmäßigerweise kontrastreich, um die Bildver-arbeitung zu vereinfachen und um Fehler zu ver-meiden. Das Ausgangssignal des Sensors wird einem Bild-verarbeitungssystem zugeführt, das die Koordinaten der Konturen und vorzugsweise auch die Typen der Bauelemente erkennt und den nächsten Ar-beitsschritt steuert, in dem mit Hilfe einer Vor-richtung die Bauelemente von der Platine entnommen werden. Die Phasen der bildpunktweise erfolgenden Bildverarbeitung erfordern ein leistungsfähiges Rechnersystem, um die von dem optischen Sensor gelieferten Bilder in speziellen Algorithmen zu verbessern und in Bereiche zu gliedern, welche die beobachteten Objekte möglichst gut approximieren. In der Phase der Merkmalsextraktion werden die charakteristischen Eigenschaften der Bauelemente erfaßt, um sie zu klassifizieren und, falls möglich, durch einen Vergleich mit einer Datenbank zu identifizieren. Die Bauelemente werden an ihrem Kantenkonturzug, den daraus ermittelbaren geometrischen Abmessungen, ihrer Farbgebung und/oder ihrer Beschriftungen mit den entsprechenden Einträgen in einer Datenbank verglichen und dadurch identifiziert. Das Bildverarbeitungssystem steuert die Vorrichtung zur Entnahme der Bauelemente, die einzelne Bauteile von der Platine entfernen kann. Zweckmäßigerweise werden zunächst nur die umweltrelevanten, also als Sondermüll zu behandelnden und die wirtschaftlich lohnenden, wiederverwendbaren Bauteile einzeln entnommen. Der Algorithmus, der entscheidet, welche Bauteile zu entnehmen sind, kann auf mögliche Änderungen der Rahmenbedingungen (z.B. gesetzliche Vorgaben) jederzeit durch einen programmtechnischen Eingriff auf den aktuellen Stand gebracht werden.

Die mit der Erfindung erzielten Vorteile bestehen insbesondere darin, daß die wiederverwendbaren und die schadstoffhaltigen, für den Sondermüll bestimmten Bauelemente von der Platine kostengünstig automatisch entfernt werden. Die wiederverwendbaren Bauteile können noch einmal benutzt werden, während die für den Sondermüll bestimmten von den anderen getrennt verbrannt oder deponiert werden können, wobei eine große Reduzierung des anfallenden Sondermülls erreicht wird. Auch die Leiterplatten sind nach einem vollständigen Entfernen der Bauelemente, das eine Voraussetzung für ein Recycling ist, nachdem sie geschreddert wurden, wiederverwendbar.

Um die Fehlersicherheit durch eine eindeutige Erkennung der Konturen der Bauelemente auch bei geringen Helligkeitskontrasten zu verbessern, ist im speziellen vorgeschlagen, daß die Beleuchtungsein-richtung einen zur Ebene der Leiterplatte näherungsweisen orthogonalen, auf der Leiterplatte punktförmigen Lichtstrahl erzeugt, daß eine Linse derart angebracht ist, daß sie den von der Leiterplatte reflektierten Lichtstrahl auf den vorzugsweise in einem geringen Abstand neben der Beleuchtungseinrichtung befestigten optischen Sensor, der ein Zeilen-Sensor ist, abbildet, daß die Beleuchtungseinrichtung einen zur Ebene der Leiterplatte näherungsweisen orthogonalen, auf der Leiterplatte punktförmigen Lichtstrahl erzeugt, eine Linse derart angebracht ist, daß sie den von der Leiterplatte reflektierten Lichtstrahl auf den vorzugsweise in einem geringen Abstand neben der Beleuchtungseinrichtung befestigten optischen Sensor, der ein Zeilen-Sensor ist, abbildet, die Achse des Sensors näherungsweise orthogonal zum reflektierten Lichtstrahl und in der durch den Spekularwinkel aufgespannten Ebene angeordnet ist und die Leiterplatte relativ zum optischen Sensor und zur Beleuchtungseinrichtung derart oberflächenparallel verschoben und/oder daß der Lichtstrahl so abgelenkt wird, daß die Leiterplatte zweidimensional abgerastert wird.

Der Grundgedanke dieser Ausführungsform besteht darin, die Oberfläche der Leiterplatte zweidimensional abzurastern und die Höhe eventuell vorhandener Bauelemente nach dem Prinzip der punktweisen Triangulation zu bestimmen. Die Beleuchtungsein-richtung liefert einen zur Leiterplatte näherungsweise orthogonalen, punktförmig darauf auftreffenden Lichtstrahl, der nach dem Reflexionsgesetz primär in den Spekularwinkel (d.h. der Einfalls- und Ausfallswinkel sind identisch) reflektiert wird. Der einfallende Lichtstrahl ist daher gewöhnlich nicht exakt orthogonal zur Oberfläche der Leiterplatte orientiert. Der reflektierte Lichtstrahl wird durch eine Linse auf den optischen Zeilensensor abgebildet, dessen Achse (also die ortsauflösend erfaßte Richtung) näherungsweise orthogonal zum reflektierten Lichtstrahl und in der durch den Spekularwinkel aufgespannten Ebene angeordnet ist. Die Richtung des reflektierten Lichtstrahls hängt von der Entfernung zwischen der Beleuchtungsein-richtung und der Oberfläche ab, da er bei einem größeren Abstand auch einen weiteren oberflächenparallelen Weg zurücklegt. Die Position des jeweils mit der höchsten Intensität beleuchteten Elements des Zeilensensors ist somit ein direktes Maß für die Entfernung zwischen der reflektierenden Oberfläche und der Beleuchtungseinrichtung bzw. dem Sensor und dient dem Bildverarbeitungssystem als Information über die Höhe eventuell vorhandener Bauelemente. Der Sensor ist aus Gründen der Kompaktheit vorzugsweise in einem geringen Abstand neben der Beleuchtungseinrichtung angebracht; ein weiterer Vorzug der dadurch entstehenden, zur Oberfläche der Leiterplatte nahezu orthogonalen Einund Ausfallswinkel besteht darin, daß unerwünschte, durch die Unterbrechung des Strahlengangs an Kanten von Bauelementen entstehende Meßfehler entscheidend reduziert sind. Die Leiterplatte wird durch oberflächenparalleles Verschieben relativ zum optischen Sensor und zur Beleuchtungseinrichtung und/oder mittels einer Ablenkung des Lichtstrahls, die beispielsweise durch einen bewegten Spiegel realisierbar ist, abgerastert, so daß dem Bildverarbeitungssystem im Ergebnis ein dreidimensionales Bild der Leiterplatte vorliegt. Die Vorzüge bestehen vornehmlich darin, daß die Konturen der Bauelemente aufgrund der dreidimensionalen Erfassung exakt erkannt werden, so daß keine Fehlbedienungen der Vorrichtung zur Entnahme der Bauelemente durch das Bildverarbeitungssystem auftreten.

Weiterhin läßt sich die Fehlerwahrscheinlichkeit dadurch verringern, daß die Beleuchtungseinrichtung einen zur Ebene der Leiterplatte näherungsweise orthogonalen, auf der Leiterplatte linienförmigen Lichtstrahl erzeugt, daß eine Linse derart befestigt ist, daß sie die von der Leiterplatte reflektierte Linie auf den vorzugsweise neben der Beleuchtungseinrichtung angeordneten optischen Sensor, der ein Flächen-Sensor ist, abbildet, und daß die Leiterplatte oberflächenparallel, orthogonal zur Linie des Lichtstrahls relativ zum optischen Sensor und zur Beleuchtungseinrichtung verschoben und abgerastert wird.

Der Kern dieser Weiterbildung besteht darin, den punktförmigen durch einen linienförmigen Lichtstrahl zu ersetzen, um mittels eines Flächensensors simultan das Höhenprofil der eindimensional beleuchteten Leiterplattenoberfläche zu erfassen. Der von der Beleuchtungseinrichtung erzeugte, möglichst senkrecht auf der Leiterplatte eintreffende, linienförmige Lichtstrahl wird reflektiert und durch eine Linse auf den gewöhnlich im Spekularwinkel angeordneten, optischen Flächensensor abgebildet. Analog zur Lehre des Anspruchs 2 erkennt das Bild-verarbeitungssystem die Höhe eines Meßpunktes anhand der Position höchster Intensität in der zur Linie orthogonalen Richtung. Da der Flächensensor alle durch den linienförmigen Lichtstrahl beleuchteten Punkte simultan erfaßt, wird die Leiterplatte lediglich in einer Richtung oberflächenparallel, orthogonal zur Linie abgerastert, d.h. relativ zum optischen Sensor und zur Beleuchtungseinrichtung verschoben. Anzumerken ist, daß auch in dieser Alternative der optische Sensor aus konstruktiven Gründen vorzugsweise neben der Beleuchtungseinrichtung befestigt ist. Neben der fehlerarmen, dreidimensionalen Erfassung der Leiterplattenoberfläche bestehen die Vorteile vornehmlich in der entscheidend verkürzten, für die Erfassung einer Leiterplatte notwendigen Zeitintervalle und somit verbesserten Wirtschaftlichkeit.

Im speziellen kann die Erkennungssicherheit des Bildverarbeitungssystem dadurch gesteigert werden, daß die Beleuchtungseinrichtung mehrere zur Ebene der Leiterplatte näherungsweise orthogonale, zueinander parallele, auf der Leiterplatte streifenförmige Lichtstrahlen erzeugt, und daß eine Linse derart angebracht ist, daß sie die von der Leiterplatte reflektierten Streifen auf den optischen Sensor, der ein Flächen-Sensor ist und vorzugsweise in einem geringen Abstand neben der Beleuchtungseinrichtung angeordnet ist, abbildet.

Die Idee besteht darin, mehrere, zueinander parallele Meßlinien gleichzeitig auf die Oberfläche der Leiterplatte zu projizieren und ebenfalls simultan mit einem Flächensensor auszuwerten. Die von der Beleuchtungseinrichtung erzeugten, streifenförmigen Strahlen treffen ebenfalls unter einem näherungsweise senkrechten Winkel auf die Oberfläche der Leiterplatte, werden reflektiert und durch eine Linse auf den normalerweise im Spekularwinkel angebrachten Flächensensor abgebildet. Die Entfernung zwischen der Beleuchtungseinrichtung und der reflektierenden Oberfläche wird durch die Lage des jeweils am hellsten beleuchteten Punktes des Flächensensors in der zu den Streifen orthogonalen Richtung repräsentiert. Der Flächensensor erfaßt jedoch im Unterschied zur Lehre des Anspruchs 3 nicht nur eine, sondern mehrere Linien gleichzeitig, so daß das Abrastern der Leiterplatte entfallen kann. Die Ein- und Ausfallswinkel der Lichtstrahlen auf der Leiterplatte werden zweckmäßigerweise (in Abhängigkeit von der Höhe der zu entstückenden Bauelemente) derart gewählt, daß die Verschiebung in der zu den Streifen senkrechten Richtung geringer bleibt als ihr Abstand, so daß eine Interferenz unterbunden ist. Der Flächensensor ist ebenfalls vorzugsweise nahe der Beleuchtungsein-richtung montiert. Die Vorteile bestehen vornehmlich darin, daß die gesamte Leiterplatte simultan durch das Bildverarbeitungssystem erfaßt wird, so daß die dazu erforderliche Zeit weiter verkürzt ist und die Entstückung preiswerter möglich wird.

Da sich die Zuordnung der einzelnen Linien zu den jeweiligen Punkten auf der Platine bei der Projektion eines einzelnen, zur Erkennung der Einzelheiten hinreichend feinen Streifenmusters als problematisch erweist, ist in einer vorteilhaften Weiterbildung der Erfindung vorgeschlagen, daß die Beleuchtungseinrichtung sukzessive Linien in unterschiedlicher Anzahl und Breite erzeugt. Die einzelnen Profillinien werden durch das Bildverarbeitungssystem anhand der bekannten, definierten Hell-Dunkel- Sequenzen identifiziert. Im einzelnen ermöglichen n unterschiedliche Streifenmuster, 2ⁿ Profillinien zu unterscheiden.

Aufgrund der relativ einfachen Zuordnung der Linien zu den einzelnen Höhenprofilen empfiehlt sich, daß die Beleuchtungseinrichtung sukzessive Linien mit jeweils verdoppelter Anzahl und halbierter Breite herstellt; alternativ ist selbstverständlich möglich, die Breite der Linien zu verdoppeln und die Anzahl zu halbieren.

Als Beleuchtungseinrichtung sind hinreichend helle, intensive, kommerziell erhältliche Laser und im speziellen Laserdioden zweckmäßig. Die ggf. zur Realisation eines linienförmigen Lichtstrahles notwendige Aufweitung des Laserstrahls ist mittels einer Zylinderlinse oder eines Schwenkspiegels unschwer möglich.

Im speziellen kann die Beleuchtungseinrichtung vorzugsweise orthogonal zur Ebene der Leiterplatte verlaufende Röntgenstrahlen emittieren und der optische Sensor auf der der Beleuchtungseinrichtung gegenüberliegenden Fläche der Leiterplatte angeordnet werden, um das Absorptionsverhalten der Bauelemente für Röntgenstrahlung zu ihrer Erkennung zu nutzen. Da in erster Linie Metalle die von der Beleuchtungseinrichtung emittierte, orthogonal auf die Leiterplatte auftreffende Röntgenstrahlung schwächen, entspricht das vom optischen Sensor auf der der Beleuchtungseinrichtung gegenüberliegenden Fläche der Leiterplatte erfaßte Bild der Dicke des durchstrahlten Metalls. Die parallel zur Röntgenstrahlung ausgerichteten Anschlußbeinchen der Bauelemente sind in Verbindung mit den zugehörigen Lötpunkten leicht erkennbar. Auch andere Metallkomponenten, wie beispielsweise Metallgehäuse, Kühlkörper, Metallkondensatoren werden eindeutig erfaßt. Als vorteilhaft ist neben der eindeutigen Identifizierung der Bauelementanschlüsse anzusehen, daß sich das Abrastern der Leiterplatte - falls ein Flächensensor Verwendung findet - erübrigt, so daß eine Leiterplatte innerhalb kürzester Zeit erfaßbar ist.

Alternativ zur Lehre des Anspruchs 1 kann die der Erfindung zugrundeliegende Aufgabe gelöst werden durch einen optischen Sensor, ein Bildverarbeitungssystem und eine Vorrichtung zur Entnahme der Bauelemente, wobei das Bildverarbeitungssystem in der Weise aufgebaut ist, daß es aus dem vom optischen Sensor gelieferten Ausgangssignal die Koordinaten der Konturen und vorzugsweise die Typen der Bauelemente erkennt und die Vorrichtung zur Entnahme der Bauelemente steuert, die Leiterplatte erwärmt wird, und der optische Sensor ein Thermosensor, vorzugsweise eine Thermokamera ist.

Der Kerngedanke besteht darin, die Leiterplatte zu erwärmen und die - aufgrund der variierenden Wärmeleitfähigkeiten - während der Aufwärmphase unterschiedlichen Temperaturen der Bauelemente und der nicht bestückten Flächen der Leiterplatte zur Identifikation der Konturen der Bauelemente mittels eines Thermosensors, vorzugsweise einer Thermokamera zu erfassen. Um ein zufriedenstellendes Signal-Rausch-Verhältnis zu erzielen, überschreitet die Temperatur der Leiterplatte die der Umgebung, ist jedoch derart gering, daß keine thermischen Beschädigungen der Bauelemente zu befürchten sind.

Als Vorzug ist insbesondere der hohe erreichbare Kontrast zwischen Bauelementen und Leiterplatte anzusehen, so daß die Vorrichtung zur Entnahme der Bauelemente durch das Bildverarbeitungssystem fehlerarm steuerbar wird. Ein Abrastern der Leiterplatte erübrigt sich, falls eine zweidimensional arbeitende Thermokamera zum Einsatz kommt.

Im speziellen kann ein Lötbad zur Erwärmung der Leiterplatte auf die erforderliche Temperatur dienen.

Bei den zur Erfassung des Lichts oder der Röntgenoder Thermo-, also Infrarotstrahlung verwendbaren Sensoren lassen sich grundsätzlich ein- und zweidimensionale Ausführungsformen unterscheiden. Während flächenhafte Sensoren direkt ein Abbild des zu untersuchenden Gegenstandes erzeugen, müssen Zeilensensoren die abzubildende Leiterplatte abrastern, weshalb sie entweder am Sensor vorbeigeführt wird (z.B. auf Transportbändern) oder ein selbständiges Ablenksystem vor dem Sensor angeordnet wird (Scanner). Aus der großen Vielfalt der Flächensensoren lassen sich die TV-orientierten Kameras, die der deutsch-amerikanischen Norm (CCIR) folgen, eine Auflösungsgenauigkeit von 1024 x 1024 Bildpunkten besitzen und relativ preiswert sind und die sogenannten normfreien Sensoren, die eine höhere Auflösung von bis zu 2048 x 2048 Bildpunkten und eine hohe Bildauflösungsfrequenz bis zu 400 Hz bieten, unterscheiden. Die Zeilensensoren liefern bis über 8000 Bildpunkte und Datenraten bis 160 MHz. Diese Systeme sind weitaus komplizierter als Flächensensoren, sind jedoch für die Aufnahme von mit konstanter Geschwindigkeit bewegten Platinen optimal anzuwenden.

Das Abrastern der Leiterplatte kann sich auch bei Flächensensoren als zweckmäßig erweisen, da die heute wirtschaftlich erhältlichen Ausführungsformen nicht in der Lage sind, größere Leiterplatten in einem einzelnen Arbeitsschritt zu erfassen. Ein weiterer Vorzug des Abrasterns besteht darin, daß sich Bauelemente doppelt aufnehmen lassen und so die meisten Aufnahmefehler auszuräumen sind. Durch dieses Verfahren wird auch ein schräges Betrachten der Bauelemente ermöglicht und die Erkennung von schräg oder seitlich angebrachten Aufschriften vereinfacht.

Falls der optische Sensor nicht nur digitale, d.h. zwischen hell und dunkel unterscheidende Ausgangssignale, sondern Grauwerte liefert, ist die Erkennung der Höhenprofile und eventuell der Typen der Bauelemente entscheidend erleichtert. Der Vorzug besteht zum einen darin, daß auch sehr stark oder schwach reflektierende Oberflächen untersucht werden können, zum anderen ist die Reflektivität der Bauelemente zu ihrer Identifikation heranziehbar.

Außerdem ist eine selbsttätige Intensitätsregelung der Beleuchtungseinrichtung empfehlenswert, da die Konturen und vorzugsweise auch die Beschriftungen extrem stark oder schwach reflektierender Bauelemente detektierbar werden.

Das Bildverarbeitungssystem benötigt einen Referenzpunkt auf der Platine, um relativ dazu die Koordinaten der Bauelemente zu ermitteln und die Vorrichtung zu ihrer Entnahme zu steuern. In einer zweckmäßigen Ausgestaltung der Erfindung wird der Schnittpunkt zweier Anschlagkanten, an denen die Platine mit zwei Greifern festgehalten wird, als Referenzpunkt verwendet. Durch das Festhalten wird verhindert, daß die Platine beim Transport oder bei der Entnahme der Bauelemente verrutscht und damit eine Störung herbeigeführt wird. Außerdem können beliebige Platinen entstückt werden, da sie im allgemeinen alle das Merkmal zweier durchgehender und benachbarter Kanten erfüllen.

Da die auf der Leiterplatte angeordneten Bauelemente, insbesondere die Halbleiter temperaturempfindlich sind, ist es nicht sinnvoll, während des Entstückungsvorganges stets die gesamte Lötseite der Leiterplatte auf der Temperatur zu belassen, bei der das Lot schmilzt. Es bietet sich daher an, nur die Lötstellen des jeweils zu entnehmenden Bauelements zu verflüssigen. Die Heizeinrichtung wird in einer geeigneten Ausführung der Erfindung ebenfalls durch das Bildverarbeitungssystem gesteuert und verflüssigt die entsprechende Lötstelle durch einen Lötschwall oder einen Strahl mit einer heißen Flüssigkeit oder Infrarotstrahlung oder Heißluft, wobei sich alle vier genannten Heizmöglichkeiten wegen ihrer guten Dosierbarkeit, Lokalisierbarkeit und der leichten Regelbarkeit der Temperatur eignen.

Der Vorteil der Verwendung einer heißen Flüssigkeit liegt in der unmittelbaren und raschen Übertragung der Wärme auf die Lötstellen, wodurch die Bauelemente geschont werden. Es bieten sich hier unbrennbare oder nur schwer entzündbare Stoffe wie Öl oder Paraffin an, besonders gut geeignet ist Glycerin.

Bei der Entstückung der Bauelemente ist zwischen bedrahteten und oberflächenmontierten Bauelementen (SMDs) zu unterscheiden. Bedrahtete Bauelemente finden sich auf fast allen Leiterplatten, daher sind entsprechende Entnahmevorrichtungen in jedem Fall erforderlich. Sind von der Leiterplatte SMDs zu entfernen, muß die Anlage zwei verschiedene, unterschiedlich ausgebildete Greifer und Heizelemente aufweisen, da die oberflächenmontierten Bauelemente an ihrer Montageseite festgelötet sind, die normalerweise der den bedrahteten Bauelementen gegenüberliegenden Seite entspricht.

Es bietet sich an, in einem ersten Arbeitsgang die SMDs zu entfernen, da sie oft temperaturempfindliche Halbleiterbauelemente enthalten. Die Lötverbindung wird während einer vom jeweiligen Bauelement abhängigen Zeitdauer erhitzt und aufgeschmolzen und das Bauelement von der Lötseite entfernt. Zum Erwärmen eignen sich Heißluft, Infrarotstrahlung oder ein Strahl einer heißen Flüssigkeit, weil sich die entsprechenden Heizelemente unabhängig von der Form der Bauelemente gestalten lassen und es ermöglichen, alle Lötpunkte eines Bauelementes zeitgleich zu erhitzen. Nachdem das Lot geschmolzen ist, wechselt die Heizeinrichtung zur Vermeidung einer Kollision mit dem Greifer zum folgenden Bauteil über und der der Bauelementeform angepaßte Greifer entnimmt das Bauelement von der Leiterplatte. Dieser Greifer ist mangels anderer Greifmöglichkeiten so gestaltet, daß er die Oberfläche des Bauelementes mit Unterdruck ansaugt.

Nach dem Entnehmen der oberflächenmontierten Bauelemente werden zweckmäßigerweise die Lötstellen der bedrahteten Bauelemente von der Lötseite her erwärmt und von einem selbstzentrierenden Greifer erfaßt und zur Bestückungsseite hin fortgezogen. Die selbstzentrierende Eigenschaft läßt sich dadurch erreichen, daß die Greifwerkzeuge schwimmend bzw. federnd gelagert sind und mit Greifschrägen versehen werden. Durch diese Eigenschaft erreicht man, daß das Bauelement auch bei einer gewissen Abweichung von seiner im Bildverarbeitungssystem gespeicherten Soll-Lage erfaßt wird. Einige Bauelemente, wie z.B. Elektrolytkondensatoren mit radialen Anschlußdrähten können nur am Bauelement selbst und nicht an ihren Drähten entnommen werden. Sollten die Anschlußdrähte der Bauelemente auf der Lötseite der Platine umgebogen sein, wird das Bauelement wie üblich entfernt, da die Wahrscheinlichkeit einer Störung oder Bauelementschädigung hier gering ist, da die bei diesem Umformprozeß auftretenden Kräfte relativ zu den Zugkräften des eigentlichen Entstückungsvorganges gering sind und zum anderen der Kraftangriffspunkt bei den meisten Bauelementen nicht an ihm selbst, sondern an dessen Anschlußdraht liegt.

Um die entnommenen Bauelemente wiederverwenden zu können bzw. dem Sondermüll zuzuführen, ist es zweckmäßig, die Erfindung so auszugestalten, daß die entnommenen Bauelemente in jeweils zugeordneten Fächern abgelegt werden. Das Bildverarbeitungssystem ist zweckmäßigerweise so zu gestalten, daß es die am häufigsten auftretenden Bauelemente in schnell zu erreichende Fächer legt und selten auftretende in langsamer zu erreichende ablegt. Die wiederverwendbaren bzw. die Sondermüll-Bauteile können, nachdem eine gewisse Anzahl an Platinen durchgelaufen ist, aus den Fächern entnommen und ihrer weiteren Verwendung zugeführt werden.

Aus wirtschaftlichen Gründen ist es nicht vertretbar, sämtliche Bauelemente mit der vom Bildverarbeitungssystem gesteuerten Entnahmevorrichtung von der Leiterplatte zu entfernen, sondern die nicht wiederverwendbaren zunächst darauf zu belassen. Diese können in einem nächsten Arbeitsschritt mit einer Massenentstückungsvorrichtung entfernt werden. Dazu bietet es sich an, eine mechanische Vorrichtung, die als Fräs- und/oder als Bürstund/oder als Schäl- und/oder als Bohr- und/oder als Absaug- und/oder als Hobeleinrichtung gestaltet ist, vorzusehen. Diese mechanischen Einrichtungen entfernen in einem Arbeitsgang sämtliche verbliebenen Bauelemente von der Leiterplatte. Alternativ zu diesen mechanischen Vorrichtungen kann man auch eine Laser-Trennvorrichtung oder eine chemische Lösungseinrichtung vorsehen, auch eine Brecheinrichtung oder eine lokale bzw. vollständige Entlötvorrichtung ist für diesen Schritt verwendbar.

Die von der Massenentstückungsvorrichtung entstückten Bauteile werden in einer weiteren, vorteilhaften Ausgestaltung der Erfindung sortiert, um die einzelnen Bauelementesorten getrennt einer Wiederverwertung zuzuführen. Diese Trennung erleichtert eine spätere Wiederverwertung erheblich.

Die vollständig entstückten Platinen werden zweckmäßigerweise von einer geeigneten Vorrichtung aufgestapelt und können später zerkleinert und verwertet werden.

Die erfindungsgemäß vorgeschlagene Vorgehensweise ist wie folgt:

Eine zu entstückende Leiterplatte wird zweckmäßigerweise zunächst gereinigt, um der Bildverarbeitung und dem Entnahmesystem ein besseres Erkennen der Bauelemente zu ermöglichen. Zur Reinigung wird die Platine in ein Tauchbad gelegt und/oder mit Ultraschall und/oder mit einem Sprühverfahren und/oder mit rotierenden Bürsten gereinigt. Bei diesem Reinigungsverfahren wird aus Umweltschutzgründen auf die Verwendung von Lösungsmitteln zu verzichtet, außerdem wird darauf geachtet, daß die maximal zulässigen Temperaturen der Bauelemente nicht überschritten werden. Es bietet sich an, kontinuierliche Reinigungsverfahren zu verwenden, die wie die genannten Verfahren direkt in den Materialfluß eingebunden werden können. Danach wird die Platine durch eine geeignete Beleuchtungseinrichtung beleuchtet und mit einem optischen Sensor abgerastert, das Ausgangssignal des Sensors vom Bild-verarbeitungssystem verarbeitet, um die Koordinaten und Typen der Bauelemente zu erkennen, und anschließend die Vorrichtung zur Entnahme der Bauelemente gesteuert. Diese entfernt zunächst die ökonomisch lohnenden, wiederverwendbaren und die schadstoffhaltigen Bauelemente und legt sie in die ihnen zugeordneten Fächer ab.

Nach ihrer Reinigung ist es bei einigen Leiterplatten erforderlich, sie von Sonder-Bauelementen zu befreien, was vorläufig noch manuell erfolgen muß. Unter der Bezeichnung Sonder-Bauelemente werden hier z.B. Transformatoren, aufgesetzte Platinen und sonstige, nicht automatisch entstückbare Bauelemente aufgefaßt. Insbesondere das Bildverarbeitungssystem ist davon abhängig, daß die Bauelemente zweidimensional auf der Leiterplatte angeordnet sind. In der erfindungsgemäßen Anlage ist die automatische Entstückung solcher Sonder-Bauelemente nicht vorgesehen, kann jedoch in einer Erweiterung ermöglicht werden.

Nach dem automatischen Entfernen der wiederverwendbaren werden die verbleibenden, nur noch verwertbaren Bauelemente mit einer Massenentstückungsvorrichtung entfernt und anschließend sortiert. Die vollständig entstückten Platinen werden aufgestapelt und verwertet.

Die ökonomisch lohnenden, entstückten Bauelemente werden hinsichtlich ihrer Funktion überprüft, nochmals gereinigt, ihre Kontakte werden gerichtet und von Lotresten befreit und neu verzinnt. Sie können dann gelagert und wiederverkauft werden.

Weitere Einzelheiten, Merkmale und Vorteile der Erfindung lassen sich dem nachfolgenden Beschreibungsteil entnehmen, in dem Ausführungsformen der Erfindung anhand der Zeichnungen näher erläutert werden. Sie zeigen in schematischer Darstellung in
- Figur 1: ein Ausschnitt einer Anlage mit einem punktförmigen Lichtstrahl
- Figur 2: ein Ausschnitt einer Anlage mit einem linienförmigen Lichtstrahl
- Figur 3: ein Ausschnitt einer Anlage mit mehreren, streifenförmigen Lichtstrahlen
- Figur 4: einen Ausschnitt einer die Leiter platte mit Röntgenstrahlen durch leuchtenden Anlage
- Figur 5: einen Ausschnitt einer die Infra rotstrahlung der Leiterplatte erfassenden Anlage
- Figur 6: eine Prinzipskizze der Verarbeitungsschritte der bestückten Leiterplatten
- Figur 7: die Erwärmung der Lötstellen oberflächenmontierter Bauelemente
- Figur 8: die Entnahme oberflächenmontierter Bauelemente von der Platine
- Figur 9: die Entnahme der bedrahteten Bauelemente
- Figur 10: eine Massenentstückungsvorrichtung

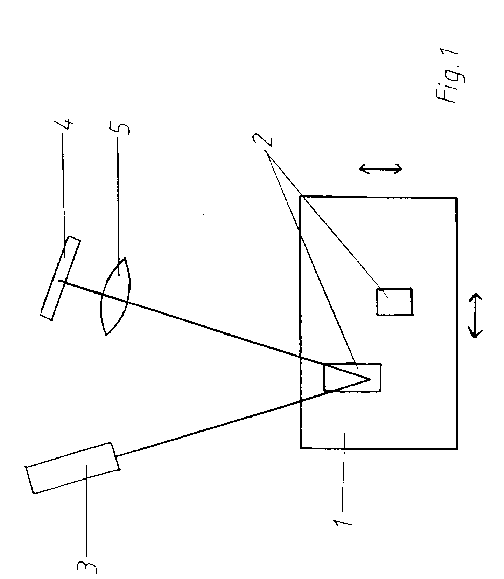

In Figur 1 ist die optische Erfassung der auf einer Leiterplatte (1) befestigten Bauelemente (2) dargestellt. Der von der Beleuchtungseinrichtung emittierte Lichtstrahl trifft unter einem nahezu senkrechten Winkel auf der Leiterplatte (1) auf. Im Spekularwinkel ist eine den Lichtpunkt auf der Leiterplatte (1) auf einen optischen Sensor (4), im dargestellten Beispiel einen Zeilensensor abbildende Linse (5) angeordnet. Die Achse des Sensors (4) ist näherungsweise orthogonal zum reflektierten Lichtstrahl und in durch den Spekularwinkel aufgespannten Ebene angeordnet. Die Leiterplatte wird zum Abrastern in den beiden oberflächenparallelen Richtungen entlang ihrer Berandungen verschoben.

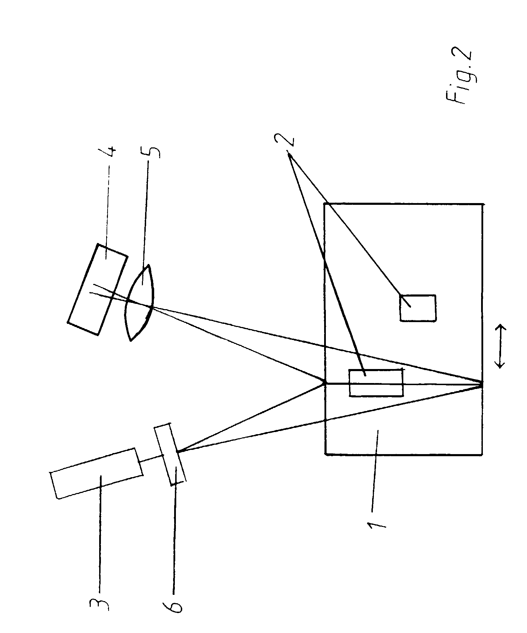

In Figur 2 wird der aus der Beleuchtungseinrichtung (3) austretende Strahl durch eine Zylinderlinse (6) zu einer zur kürzeren Berandung der Leiterplatte (1) parallelen Linie aufgeweitet. Die ebenfalls im Spekularwinkel angeordnete Linse (5) bildet den reflektierten Lichtstrahl auf dem im dargestellten Beispiel zweidimensional arbeitenden optischen Sensor (4) ab. Zum Abrastern wird die Leiterplatte (1) lediglich in der zur Linie orthogonalen, oberflächenparallelen Richtung verschoben.

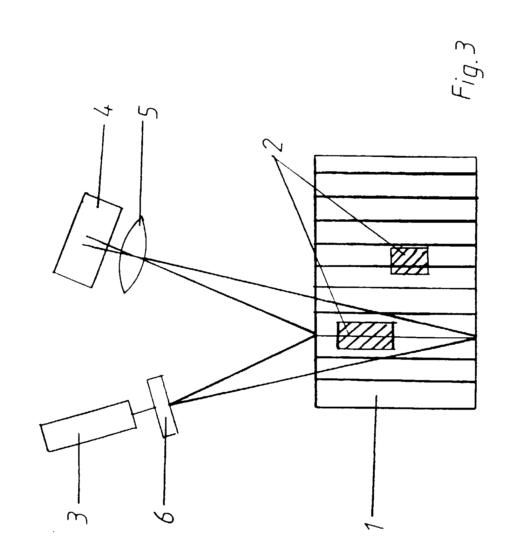

Bei der in Figur 3 dargestellten Anlage wird im Gegensatz zu der vorhergehenden Zeichnung durch die Beleuchtungseinrichtung (3) ein Streifenmuster auf der Leiterplatte (1) erzeugt. Die Anordnung des Sensors (4) und der Linse (5) unterscheidet sich hingegen nicht. Durch das Streifenmuster wird die gesamte Leiterplatte (1) simultan abgetastet; ein Abrastern erübrigt sich. Die Beleuchtungseinrichtung (3) kann zur Erleichterung der Identifikation der reflektierten Linien sukzessive Streifen in unterschiedlicher Anzahl und/oder Breite emittieren.

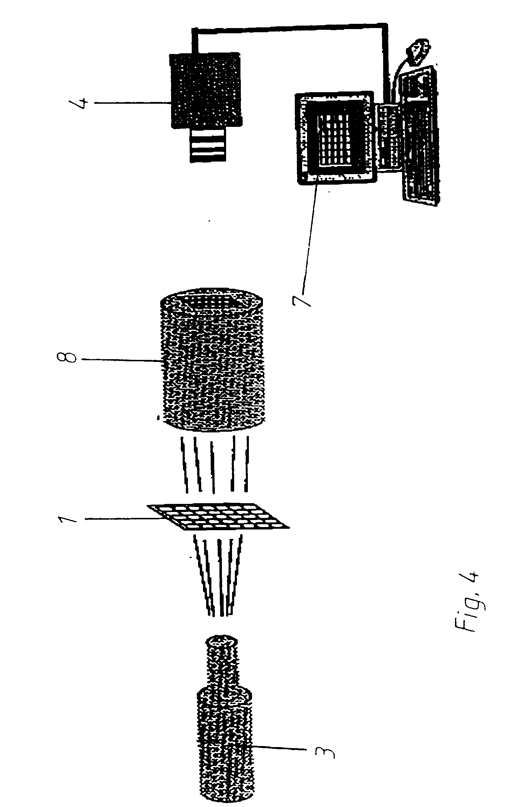

Bei der in Figur 4 dargestellten Anlage wird die Leiterplatte (1) durch die Röntgenstrahlen liefernde Beleuchtungseinrichtung (3) durchstrahlt. Die transmittierten Photonen werden durch einen Filter (8) an einen optischen Sensor (4) weitergeleitet. Das auf einem Meßrechner (7) implementierte Bildverarbeitungssystem erkennt die Konturen der Bauelemente (2) anhand der absorbierten Röntgenstrahlung und steuert die in der Zeichnung nicht dargestellte Vorrichtung zur Entnahme der Bauelemente (2).

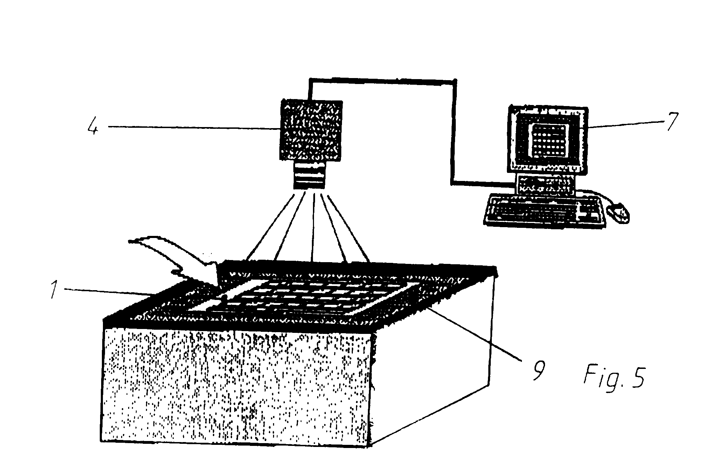

In Figur 5 wird die Leiterplatte (1) durch ein Lötbad erwärmt. Die emittierten Infrarotstrahlen werden durch den optischen Flächensensor (4), d.h. eine Thermokamera erfaßt und dem Meßrechner (7) zugeführt. Die Konturen der Bauelemente (2) werden anhand ihrer aufgrund der unterschiedlichen Wärmeleitfähigkeit von der eigentlichen Leiterplatte (1) abweichenden, geringeren Temperatur erkannt.

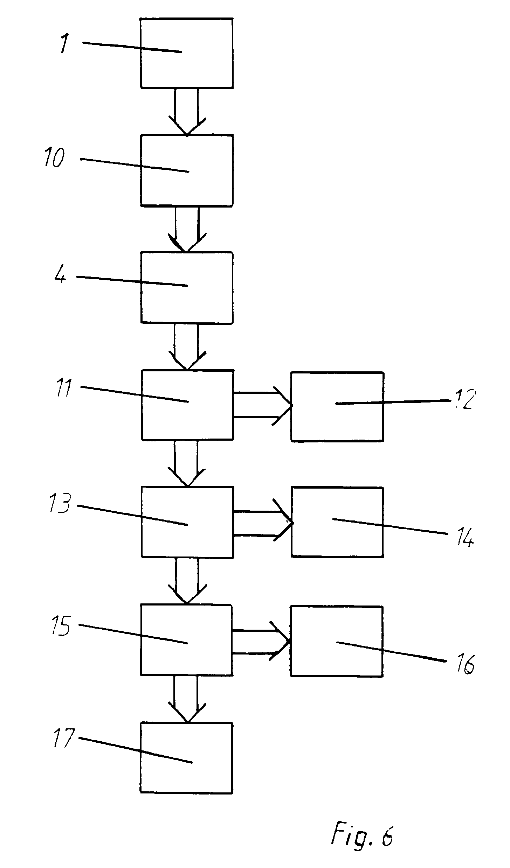

Die in Figur 6 dargestellte Leiterplatten-Entstückung läuft prinzipiell so ab, daß die mit elektronischen Bauelementen (12, 14, 16) bestückten Leiterplatten (1) in einem ersten Verarbeitungsschritt (10) gereinigt werden. Anschließend werden die Leiterplatten (1) von einer geeigneten Einrichtung beleuchtet und mit einem optischen Sensor (4) abgerastert. Das Ausgangssignal dieses Sensors (4) wird vom Bildverarbeitungssystem benutzt, um die Position und die Typen der Bauelemente (12, 14) auf der Platine (1) zu errechnen, indem ein Vergleich der Konturen, Farbe, Form und Beschriftung mit einer Datenbank vorgenommen wird. Das Bildverar-beitungssystem steuert den nächsten Verarbeitungs-schritt, bei dem von einer Entnahmevorrichtung (11) für oberflächenmontierte Bauelemente (12) mit einem mit Unterdruck arbeitendem Greifer (20) diese von der Leiterplatte (1) entnommen werden. Diese Bau-elemente (12) können wiederverwendet werden. Im nächsten Verarbeitungsschritt werden mit Draht-anschlüssen versehene Bauelemente (14) von einer geeigneten Entnahmevorrichtung (13) mit einem das Bauteil (14) mechanisch erfassenden Greifer (21) von der Leiterplatte (1) entfernt. Die entnommenen bedrahteten Bauelemente (14) können wie die oberflächenmontierten (12) wiederverwendet bzw. dem Sondermüll zugeführt werden. Auf der Leiterplatte (1) verbleiben nur noch verwertbare Bauelemente (16). Diese werden in einer Massenentstückungs-vorrichtung (15) von der Leiterplatte (1) entfernt, die anschließend völlig frei von Bauelementen (12, 14, 16) ist und ebenfalls verwertet werden kann. Die vollständig entstückte Platine (17) wird aufgestapelt und verwertet.

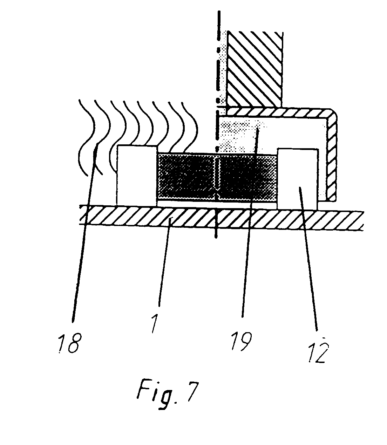

In Figur 7 sind zwei Möglichkeiten zur Verflüssigung der Lötstellen an oberflächenmontierten Bauelementen (12) dargestellt. Im linken Bildteil erkennt man Infrarotstrahlen (18), die die Lötstelle des Bauelementes (12) auf der Platine (1) erwärmen und verflüssigen, während im rechten Teil eine Heißluftquelle (19) die Lötstelle verflüssigt.

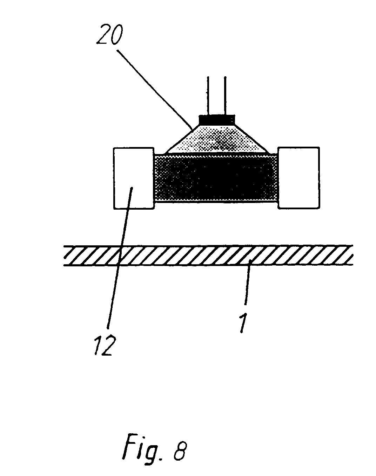

In Figur 8 wird ein von der Platine (1) durch einen Unterdrucksauger (20), der sich an der Oberfläche des Bauelementes (12) festgesaugt hat, entnommenes oberflächenmontiertes Bauelement (12) dargestellt.

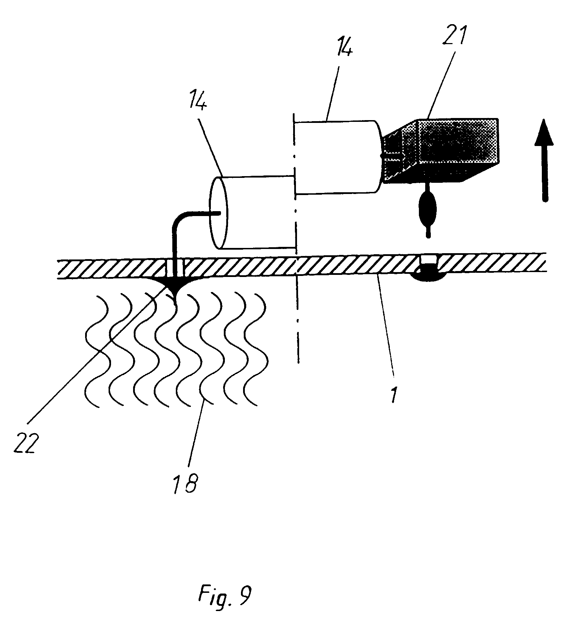

Figur 9 zeigt das Entnehmen der bedrahteten Bauelemente (14) von der Platine (1). Die Lötstelle (22) wird auch hier durch Infrarotstrahlen (18) zum Schmelzen gebracht, woraufhin ein Greifer (21) das Bauelement (14) von der Platine (1) abhebt und wegtransportiert.

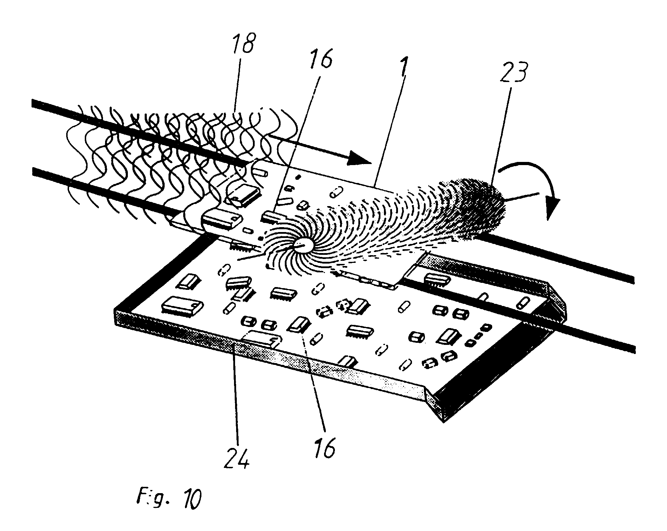

Schließlich stellt Figur 10 eine Massenentstückungsvorrichtung (15) dar. Die Lötstellen der Bauelemente (16) auf der Platine (1) werden durch Infrarotstrahlen (18) verflüssigt. Eine rotierende Bürste (23) entfernt danach mechanisch die Bauelemente (16), die in einer Auffangwanne (24) gesammelt, sortiert und wiederverwertet werden.

Im Ergebnis erhält man eine Anlage zur automatischen Entstückung von mit elektronischen Bauelementen bestückten Leiterplatten, die sich durch eine fehlerarme, schnelle Erkennung der Konturen der Bauelemente sowie durch Wirtschaftlichkeit auszeichnet.

## Patentansprüche

1. Anlage zur automatischen Entstückung von mit elektronischen Bauelementen bestückten Leiterplatten, **gekennzeichnet durch** eine Beleuchtungsein-richtung zur Ausleuchtung der Leiterplatten (1), einen optischen Sensor (4), ein Bildverarbeitungssystem und eine Vorrichtung (11, 13) zur Entnahme der Bauelemente (12, 14), wobei das Bildver-arbeitungssystem in der Weise aufgebaut ist, daß es aus dem vom optischen Sensor (4) gelieferten Ausgangssignal die Koordinaten der Konturen und vorzugsweise die Typen der Bauelemente (12, 14) erkennt und die Vorrichtung (11, 13) zur Entnahme der Bauelemente (12, 14) steuert.

2. Anlage nach Anspruch 1, **dadurch gekennzeichnet,** daß die Beleuchtungseinrichtung (3) einen zur Ebene der Leiterplatte (1) näherungsweisen orthogonalen, auf der Leiterplatte (1) punktförmig auftreffenden Lichtstrahl erzeugt,
daß eine Linse (5) derart angebracht ist, daß sie den von der Leiterplatte (1) reflektierten Lichtstrahl auf den vorzugsweise in einem geringen Abstand neben der Beleuchtungseinrichtung (3) befestigten optischen Sensor (4), der ein Zeilen-Sensor ist, abbildet,
daß die Achse des Sensors (4) näherungsweise orthogonal zum reflektierten Lichtstrahl und in der durch den Spekularwinkel aufgespannten Ebene angeordnet ist und
daß die Leiterplatte (1) relativ zum optischen Sensor (4) und zur Beleuchtungseinrichtung (3) derart oberflächenparallel verschoben und/oder daß der Lichtstrahl so abgelenkt wird, daß die Leiterplatte (1) zweidimensional abgerastert wird.

3. Anlage nach Anspruch 1, **dadurch gekennzeichnet,** daß die Beleuchtungseinrichtung (3) einen zur Ebene der Leiterplatte (1) näherungsweise orthogonalen, auf der Leiterplatte (1) linienförmig auftreffenden Lichtstrahl erzeugt,
daß eine Linse (5) derart befestigt ist, daß sie die von der Leiterplatte (1) reflektierte Linie auf den vorzugsweise neben der Beleuchtungseinrichtung (3) angeordneten optischen Sensor (4), der ein Flächen-Sensor ist, abbildet, und
daß die Leiterplatte (1) oberflächenparallel, orthogonal zur Linie des Lichtstrahls relativ zum optischen Sensor (4) und zur Beleuchtungsein-richtung (3) verschoben und abgerastert wird.

4. Anlage nach Anspruch 1, **dadurch gekennzeichnet,** daß die Beleuchtungseinrichtung (3) mehrere zur Ebene der Leiterplatte (1) näherungsweise orthogonale, zueinander parallele, auf der Leiterplatte (1) streifenförmige Lichtstrahlen erzeugt, und daß eine Linse (5) derart angebracht ist, daß sie die von der Leiterplatte (1) reflektierten Streifen auf den optischen Sensor (4), der ein Flächen-Sensor ist und vorzugsweise in einem geringen Abstand neben der Beleuchtungseinrichtung (3) angeordnet ist, abbildet.

5. Anlage nach Anspruch 4, **dadurch gekennzeichnet,** daß die Beleuchtungseinrichtung (3) sukzessive Linien in unterschiedlicher Anzahl und/oder Breite erzeugt.

6. Anlage nach Anspruch 5, **dadurch gekennzeichnet,** daß die Beleuchtungseinrichtung (3) sukzessive Linien in jeweils verdoppelter Anzahl und halbierter Breite herstellt.

7. Anlage nach einem der Ansprüche 1 bis 6, **gekennzeichnet durch** einen Laser, bspw. eine Laserdiode als Beleuchtungseinrichtung (3).

8. Anlage nach Anspruch 1, **dadurch gekennzeichnet,** daß die Beleuchtungseinrichtung (3) vorzugsweise orthogonal zur Ebene der Leiterplatte (1) verlaufende Röntgenstrahlen emittiert, und
daß der optische Sensor (4) auf der der Beleuchtungseinrichtung (3) gegenüberliegenden Fläche der Leiterplatte (1) angeordnet ist.

9. Anlage zur automatischen Entstückung von mit elektronischen Bauelementen bestückten Leiterplatten, **gekennzeichnet durch** einen optischen Sensor (4), ein Bildverarbeitungssystem und eine Vorrichtung (11, 13) zur Entnahme der Bauelemente (12, 14), wobei das Bildverarbeitungssystem in der Weise aufgebaut ist, daß es aus dem vom optischen Sensor (4) gelieferten Ausgangssignal die Koordinaten der Konturen und vorzugsweise die Typen der Bauelemente (12, 14) erkennt und die Vorrichtung (11, 13) zur Entnahme der Bauelemente (12, 14) steuert, die Leiterplatte (1) erwärmt wird und der optische Sensor (4) ein Thermosensor, vorzugsweise eine Thermokamera ist.

10. Anlage nach Anspruch 9, **dadurch gekennzeichnet,** daß die Leiterplatte (1) durch ein Lötbad (9) erwärmt wird.

11. Anlage nach einem der Ansprüche 1 bis 10, **dadurch gekennzeichnet,** daß der optische Sensor ein Zeilen- oder Flächensensor ist.

12. Anlage nach einem der Ansprüche 1 bis 11, **dadurch gekennzeichnet,** daß der optische Sensor die Leiterplatte (1) abrastert.

13. Anlage nach einem der Ansprüche 1 bis 12, **dadurch gekennzeichnet,** daß der optische Sensor (4) Grauwerte erfaßt.

14. Anlage nach einem der Ansprüche 1 bis 13, **gekennzeichnet durch** eine selbsttätige Intensitätsregelung der Beleuchtungseinrichtung (3).

15. Anlage nach einem der Ansprüche 1 bis 14, **dadurch gekennzeichnet,** daß das Bildverarbeitungssystem so gestaltet ist, daß es den Schnittpunkt zweier Anschlagkanten, an denen die Leiterplatte (1) mit zwei Greifern festgehalten ist, als Referenzpunkt benutzt.

16. Anlage einem der Ansprüche 1 bis 15, **dadurch gekennzeichnet,** daß das Bildverarbeitungssystem ein Heizelement steuert, das lokal die Lötstellen (22) der Anschlüsse der Bauelemente (2) von der Lötseite der Leiterplatte (1) her durch einen Lötschwall oder einen Strahl einer heißen Flüssigkeit oder Infrarotstrahlung (18) oder Heißluft (19) kurzzeitig auf eine Temperatur bringt, bei der das Lot schmilzt.

17. Anlage nach einem der Ansprüche 1 bis 16, **gekennzeichnet durch** Öl oder Paraffin oder Glycerin als heiße Flüssigkeit.

18. Anlage nach einem der Ansprüche 1 bis 17, **dadurch gekennzeichnet,** daß die Vorrichtung (11, 13) zur Entnahme der Bauelemente (12, 14) einen Greifer (20) aufweist, der die Bauelemente (12) mit Unterdruck ansaugt.

19. Anlage nach Anspruch 18, **dadurch gekennzeichnet,** daß der Greifer (20) auf der Lötseite der Leiterplatte (1) angeordnet ist.

20. Anlage nach Anspruch 18 oder 19, **dadurch gekennzeichnet,** daß der Greifer (20) nach Verflüssigen des Lotes und nach dem Entfernen des Heizelements auf das Bauelement (12) aufgesetzt wird.

21. Anlage nach einem der Ansprüche 1 bis 20, **dadurch gekennzeichnet,** daß die Vorrichtung (11, 13) zur Entnahme der Bauelemente (12, 14) einen Greifer (21) aufweist, der die Anschlußdrähte der Bauelemente (14) oder die Bauelemente (14) selbst mechanisch erfaßt.

22. Anlage nach Anspruch 21, **dadurch gekennzeichnet,** daß der Greifer (21) schwimmend und/oder federnd gelagert und mit Greifschrägen versehen ist.

23. Anlage nach Anspruch 21 oder 22, **dadurch gekennzeichnet,** daß der Greifer (21) auf der Bestükkungsseite der Leiterplatte (1) angeordnet ist.

24. Anlage nach einem der Ansprüche 18 bis 23, **dadurch gekennzeichnet,** daß der mit Unterdruck arbeitende Greifer (20) die oberflächenmontierten Bauelemente (22) entstückt, und daß der die Bauelemente (14) mechanisch erfassende Greifer (21) die bedrahteten Bauelemente (14) erfaßt, wobei das Bildverarbeitungssystem in der Regel zunächst den mit Unterdruck arbeitenden Greifer (20) und anschließend den mechanischen Greifer (21) steuert.

25. Anlage nach einem der Ansprüche 1 bis 24, **dadurch gekennzeichnet,** daß den entnommenen Bauelementen (12, 14) zugeordnete Fächer vorhanden sind, wobei das Bildverarbeitungssystem die Vorrichtung zur Entnahme (11, 13) der Bauelemente (12, 14) derart steuert, daß sie die entnommenen Bauelemente (12, 14) in den jeweils zugeordneten Fächern ablegt.

26. Anlage nach einem der Ansprüche 1 bis 25, **dadurch gekennzeichnet,** daß eine Massenentstückungsvorrichtung (15) vorhanden ist, die mit einer Fräsoder einer Bürsten- (23) oder einer Schäl- oder einer Bohr- oder einer Absaug- oder einer Hobel oder einer lokalen bzw. vollständigen Entlöt- oder einer Brech- oder einer Lasertrenn- oder einer chemischen Lösungseinrichtung versehen ist.

27. Anlage nach Anspruch 26, **dadurch gekennzeichnet,** daß eine Sortiervorrichtung vorhanden ist, die die von der Massenentstückungsvorrichtung (15) entstückten Bauelemente (16) sortiert.

28. Anlage nach einem der Ansprüche 1 bis 27, **dadurch gekennzeichnet,** daß eine Stapelvorrichtung vorhanden ist, die so gestaltet ist, daß die vollständig entstückten Leiterplatten (17) aufgestapelt werden können.

29. Verfahren zur automatischen Entstückung von mit elektronischen Bauelementen bestückten Leiterplatten unter Verwendung einer Anlage nach einem der Ansprüche 1 bis 28, **dadurch gekennzeichnet,** daß die Leiterplatten (1) mit Ultraschall und/oder in einem Tauchbad und/oder mit einem Sprühverfahren und/oder mit rotierenden Bürsten gereinigt werden,
daß sie mit einer Beleuchtungseinrichtung reflexfrei beleuchtet und mit einem optischen Sensor (4) abgerastert werden,
daß das Ausgangssignal des optischen Sensors (4) vom Bildverarbeitungssystem verwendet wird, um die Koordinaten der Konturen und vorzugsweise die Typen der Bauelemente (12, 14) zu erkennen
und daß die Vorrichtung (11, 13) zur Entnahme der Bauelemente (12, 14) schadstoffhaltige und ökonomisch lohnende Bauelemente (12, 14) vom Bildverarbeitungssystem gesteuert von der Leiterplatte (1) entfernt und in zugeordnete Fächer ablegt, während die Lötstellen (22) der jeweiligen Bauelemente (12, 14) lokal erwärmt werden.

30. Verfahren nach Anspruch 29, **dadurch gekennzeichnet,** daß die Leiterplatten (1) nach dem Reinigen von Sonderbauelementen, aufgesetzten Schaltungsträgern und sonstigen, nicht automatisch entstückbaren Bauelementen (12, 14) befreit werden.

31. Verfahren nach Anspruch 29 oder 30, **dadurch gekennzeichnet,** daß die entstückten ökonomisch lohnenden Bauelemente (12, 14) sämtlich auf Funktion überprüft, nochmals gereinigt, ihre Kontakte gerichtet und von Lotresten befreit und neu verzinnt werden.

## Claims

1. System for the automatic disassembly of printed circuit boards with mounted electronic components, **wherein** there is a lighting device for illuminating said printed circuit boards (1), an optical sensor (4), an image processing system and a device (11, 13) for the removal of components (12, 14), whereby the image processing system is designed in such a way that from the output signal delivered by said optical sensor (4) it recognises the co-ordinates of the contours and preferably the types of components (12, 14) and controls the device (11, 13) for removing components (12, 14).

2. System according to claim 1, **wherein** said lighting device (3) creates a punctual light beam on said printed circuit board (1), which is approximately orthogonal to the plane of said printed circuit board (1),
that a lens (5) is disposed in such a way that it projects the light beam reflected by said printed circuit board (1) on to said optical sensor (4), which is a line sensor and is preferably affixed at a short distance adjacent to said lighting device (3),
that the axis of said sensor (4) is approximately orthogonal to the reflected light beam and is arranged in the plane formed by the specular angle and
that said printed circuit board (1) is displaced surface-parallel relative to said optical sensor (4) and to said lighting device (3) in such a way, and/or that the light beam is deflected, so that said printed circuit board (1) is scanned two-dimensionally.

3. System according to claim 1, **wherein** said lighting device (3) creates a linear light beam on said printed circuit board (1), which is approximately orthogonal to said printed circuit board (1),
that a lens (5) is disposed in such a way that it projects the light beam reflected by said printed circuit board (1) on to said optical sensor (4), which is a surface-area sensor and is preferably affixed at a short distance adjacent to said lighting device (3),
that said printed circuit board (1) is displaced surface-parallel, orthogonally to the line of the light beam relative to said optical sensor (4) and to said lighting device (3) and is scanned.

4. System according to claim 1, **wherein** said lighting device (3) creates a plurality of stripe-like light beams on said printed circuit board (1), which are approximately orthogonal to the plane of said printed circuit board (1) and are parallel to one another, and
that a lens (5) is disposed in such a way that it projects the stripes reflected by said printed circuit board (1) on to said optical sensor (4), which is a surface-area sensor and is preferably arranged at a short distance adjacent to said lighting device (3).

5. System according to claim 4, **wherein** said lighting device (3) creates successive lines in differing numbers and/or width.

6. System according to claim 5, **wherein** said lighting device (3) produces double the number of successive lines and of half the width.

7. System according to one of claims 1 to 6, **wherein** said lighting device (3) is a laser, for example a laser diode.

8. System according to claim 1, **wherein** said lighting device (3) emits x-rays extending preferably orthogonal to the plane of said printed circuit board (1), and that said optical sensor (4) is disposed on the surface of said printed circuit board (1) opposite to said lighting device (3).

9. System for the automatic disassembly of printed circuit boards with mounted electronic components, **wherein** there is an optical sensor (4), an image processing system and a device (11, 13) for the removal of components (12, 14), whereby the image processing system is designed in such a way that from the output signal delivered by said optical sensor (4) it recognises the co-ordinates of the contours and preferably the types of components (12. 14) and controls the device (11, 13) for removing components (12, 14), said printed circuit board (1) is heated, and said optical sensor (4) is a thermal sensor, preferably a thermal camera.

10. System according to claim 9, **wherein** said printed circuit board (1) is heated by means of a solder bath (9).

11. System according to one of claims 1 to 10, **wherein** said optical sensor is a line or surface-area sensor.

12. System according to one of claims 1 to 11, **wherein** said optical sensor scans said printed circuit board (1).

13. System according to one of claims 1 to 12, **wherein** said optical sensor (4) records grey scales.

14. System according to one of claims 1 to 13, **wherein** the intensity of said lighting device (3) is automatically controlled.

15. System according to one of claims 1 to 14, **wherein** said image processing system is designed in such a way that it uses the intersecting point of two locating edges, at which said printed circuit board (1) is affixed by two grippers, as a reference point.

16. System according to one of claims 1 to 15, **wherein** said image processing system controls a heating element which locally briefly raises the temperature of the soldered connections (22) of components (2) from the solder side of said printed circuit board (1) by means of a solder wave or a jet of a hot liquid or infrared radiation (18) or hot air (19) so that the solder melts.

17. System according to one of claims 1 to 16, **wherein** the hot liquid is oil or paraffin or glycerine.

18. System according to one of claims 1 to 17, **wherein** said device (11, 13) for the removal of components (12, 14) has a gripper (20), which takes up components (12) by means of negative pressure suction.

19. System according to claim 18, **wherein** said gripper (20) is disposed on the solder side of said printed circuit board (1).

20. System according to claim 18 or 19, **wherein** said gripper (20) is placed upon said component (12) after liquefaction of the solder and after the removal of the heating element.

21. System according to one of claims 1 to 20, **wherein** said device (11, 13) for the removal of components (12, 14) has a gripper (21), which grasps mechanically the leads of components (14) or the components (14) themselves.

22. System according to claim 21, **wherein** said gripper (21) is float and/or spring mounted and is provided with gripping cants.

23. System according to claim 21 or 22, **wherein** said gripper (21) is disposed on the mounting side of said printed circuit board (1).

24. System according to one of claims 18 to 23, **wherein** said gripper (20) that functions with negative pressure disassembles the surface mounted components (22) and that gripper (21) that grasps components (14) mechanically grasps the wired components (14), whereby the image processing system usually first controls gripper (20) that functions with negative pressure and then mechanical gripper (21).

25. System according to one of claims 1 to 24, **wherein** there are receptacles provided assigned to removed components (12, 14), whereby said image processing system controls the device for the removal (11, 13) of components (12. 14) in such a way that it deposits removed components (12, 14) in the respectively assigned receptacles.

26. System according to one of claims 1 to 25, **wherein** there is a mass disassembly device (15) which is provided with a milling or a brushing (23) or a paring or a drilling or a suction or a planing or a local or complete desoldering or a breaking or a laser separation or a chemical solvent device.

27. System according to claim 26, **wherein** there is a sorting device which sorts the components (16) disassembled by said mass disassembly device (15).

28. System according to one of claims 1 to 27, **wherein** there is a stacking device which is designed in such a way that the completely disassembled printed circuit boards (17) can be stacked.

29. Method for the automatic disassembly of printed circuit boards with mounted electronic components under the use of a system according to one of claims 1 to 28, **wherein** said printed circuit boards (1) are cleaned by ultrasound and/or in an immersion bath and/or by a spraying method and/or by rotating brushes,
that they are illuminated in a reflexfree manner by a lighting device and scanned with an optical sensor (4),
that the output signal of said optical sensor (4) is used by the image processing system in order to recognise the co-ordinates of the contours and preferably the types of said components (12, 14),
and that said device (11, 13) for the removal of said components (12, 14) removes economically profitable components and those containing pollutants (12, 14) from said printed circuit board (1) controlled by said image processing system and deposits them in assigned receptacles, while the soldered connections (22) of the respective components (12, 14) are heated locally.

30. Method according to claim 29, **wherein** said printed circuit boards (1) are, after cleaning, freed of special components, superimposed circuit carriers and other components (12, 14) which cannot be disassembled automatically.

31. Method according to one of claims 29 or 30, **wherein** the disassembled economically profitable components (12, 14) are all checked as concerns function, recleaned, the contacts straightened and freed of solder residual and re-tinned.

## Revendications

1. Installation à déséquiper automatiquement des cartes imprimées équipées de composants électroniques **caractérisée par** un système d'éclairage pour éclairer les plaques imprimées (1), un détecteur optique (4), un système de traitement de l'image et un dispositif (11, 13) pour retirer les composants (12,14), le système de traitement de l'image étant conçu de telle manière qu'il reconnaît, par le signal de sortie livré par le détecteur optique (4) les coordonnées des contours et de préférence, le type des composants (12,14) et commande le dispositif (11,13) pour retirer les composants (12,14).

2. Installation selon la revendication 1, **caractérisée en ce que** le système d'éclairage (3) produit un rayon lumineux ponctuel qui tombe pratiquement en angle droit sur la surface de la carte imprimée (1),
en ce qu'une lentille (5) est placée de telle façon qu'elle représente le rayon lumineux réfléchi par la carte imprimée (1) sur le détecteur optique (4), qui est un détecteur de lignes et qui, est installé, de préférence, à côté du système d'éclairage (3) et à une faible distance de celui-ci,
en ce que l'axe du détecteur (4) est pratiquement perpendiculaire au rayon lumineux réfléchi et est situé dans le plan de l'angle de réflexion et
en ce que la carte imprimée (1) est déplacée par rapport au détecteur optique (4) et au système d'éclairage (3) parallèlement à la surface et/ou que le rayon lumineux est dévié de telle façon que la carte imprimée (1) est balayée en deux dimensions.

3. Installation selon la revendication 1, **caractérisée en ce que** le système d'éclairage (3) produit un rayon lumineux tombant pratiquement à angle droit sur la surface la carte imprimée (1) et produisant un rayon linéaire sur la plaque imprimée (1),
en ce qu'une lentille (5) est fixée de telle façon qu'elle représente la ligne réfléchie sur le détecteur optique (4) qui est un détecteur de surface et qui est placé de préférence à côté du système d'éclairage (3) et
en ce que la carte imprimée (1) est déplacée et balayée parallèlement à la surface et perpendiculairement à la ligne du rayon lumineux par rapport au détecteur optique (4) et au système d'éclairage (3).

4. Installation selon la revendication 1, **caractérisée en ce que** le système d'éclairage (3) produit sur la carte imprimée plusieurs rayons lumineux en forme de bande parallèles entre elles tombant pratiquement à angle droit sur la surface de la carte imprimée (1) et qu'une lentille (5) est placée de telle façon qu'elle représente les bandes réfléchies par la carte imprimée (1) sur le détecteur optique (4) qui est un détecteur de surface et qui est placé de préférence à une faible distance du système d'éclairage (3) et à côté de celui-ci.

5. Installation selon la revendication 4 **caractérisée en ce que** le système d'éclairage (3) produit des lignes successives en nombre et/ou largeur variables.

6. Installation selon la revendication 5 **caractérisée en ce que** le système d'éclairage (3) produit des lignes successives qui sont respectivement du double en nombre et de la moitié en largeur.

7. Installation selon une des revendications 1 à 6 **caractérisée en ce que** le système d'éclairage (3) est un laser, par exemple, une diode laser.

8. Installation selon la revendication 1 **caractérisée en ce que** le système d'éclairage (3) émet des rayons X de préférence perpendiculaires à la surface de la carte imprimée (1) et que le détecteur optique (4) est placé sur la surface de la carte imprimée (1) opposée au système d'éclairage (3).

9. Installation à déséquiper automatiquement les cartes imprimées équipées de composants électroniques **caractérisée par** un détecteur optique (4), un système de traitement des images et un dispositif (11, 13) pour retirer les composants (12,14), le système de traitement des images étant installé de telle façon qu'il reconnaît les coordonnées des contours et, de préférence, le type des composants (12, 14) par le signal de sortie livré par le détecteur optique (4) et qu'il commande le dispositif (11, 13) pour retirer les composants (12, 14), par le fait que la carte imprimée (1) est chauffée et que le détecteur optique (4) est un détecteur thermique, de préférence une caméra thermique.

10. Installation selon la revendication 9 **caractérisée en ce que** la carte imprimée (1) est chauffée par un bain de brasage (9).

11. Installation selon une des revendications 1 à 10 **caractérisée en ce que** le détecteur optique est un détecteur de lignes ou de surface.

12. Installation selon une des revendications 1 à 11 **caractérisée en ce que** le détecteur optique balaie la carte imprimée (1).

13. Installation selon une des revendications 1 à 12 **caractérisée en ce que** le détecteur optique (4) saisit les valeurs de gris.

14. Installation selon une des revendications 1 à 13 **caractérisée par** un réglage automatique de l'intensité du système d'éclairage (3).

15. Installation selon une des revendications 1 à 14 **caractérisée en ce que** le système de traitement de l'image est conçu de telle façon qu'il utilise comme point de référence l'intersection de deux bords par lesquels est fixée la carte imprimée (1) à l'aide deux griffes de fixation.

16. Installation selon une des revendications 1 à 15 **caractérisée en ce que** le système de traitement de l'image commande un élément de chauffage qui porte localement pour une brève durée de temps, les brasures (22) des connexions des composants (2) du côté brasage de la carte imprimée (1) à une température qui fait fondre la soudure que ce soit par une vague de brasage? ou par un jet d'un liquide porté à haute température ou encore par un rayon infrarouge (18) ou par de l'air chaud (19).

17. Installation selon une des revendications 1 à 16 **caractérisée en ce que** le liquide chaud est de l'huile ou la paraffine ou de la glycérine.

18. Installation selon une des revendications 1 à 17 **caractérisée en ce que** le dispositif (11, 13) pour retirer les composants (12, 14) dispose d'un preneur (20) qui aspire les composants (12) par le vide.

19. Installation selon la revendication 18 **caractérisée en ce que** le preneur (20) est placé sur le côté brasage de la carte imprimée (1).

20. Installation selon la revendication 18 ou 19 **caractérisée en ce que** le preneur (20) est placé sur le composant (12) après que la soudure est fondue et après que l'élément de chauffage a été retiré.

21. Installation selon les revendications 1 à 20 **caractérisée en ce que** le dispositif (11, 13) pour retirer les composants (12, 14) est muni d'un preneur (21) qui saisit mécaniquement les sorties des composants (14) ou les composants eux-mêmes.

22. Installation selon la revendication 21 **caractérisée en ce que** le preneur (21) est logé de façon flottante et/ou sur ressorts et est muni de biseaux de prise.

23. Installation selon la revendication 21 ou 22 **caractérisée en ce que** le preneur (21) est placé sur le côté composant de la carte imprimée (1).

24. Installation selon une des revendications 18 à 23 **caractérisée en ce que** le preneur travaillant avec le vide (20) retire les composants (22) montés sur la surface et que le preneur (21) qui saisit mécaniquement les composants (14), saisit les composants câblés (14), le système de traitement de l'image commandant alors en règle générale tout d'abord le preneur qui travaille avec du vide (20) et ensuite le preneur mécanique (21).

25. Installation selon une des revendications 1 à 24 **caractérisée en ce que** des cases attribuées sont prévues pour placer les composants retirés (12, 14), le système de traitement de l'image commandant le dispositif pour retirer (11, 13) les composants (12, 14) de telle sorte que les composants (12, 14) retirés sont placés dans les cases qui leur sont attribuées.

26. Installation selon une des revendications 1 à 25 **caractérisée en ce qu'un** dispositif pour retirer les composants en masse (15) est prévu doté d'un système de fraisage ou de brosses (23) ou d'un système séparateur ou de perçage ou d'aspiration ou d'un rabot ou d'un système local ou complet de désoudage ou d'un système de cisaillement ou de séparation au laser ou de dissolution chimique.

27. Installation selon la revendication 26 **caractérisée en ce qu'un** dispositif de tri est présent qui trie les composants (16) retirés par le dispositif pour retirer les composants en masse (15).

28. Installation selon une des revendications 1 à 27 **caractérisée en ce qu'un** dispositif d'empilage est présent qui est conçu de telle façon que les cartes imprimées entièrement déséquipées (17) peuvent être empilées.

29. Procédé pour déséquiper automatiquement les cartes imprimées équipées de composants électroniques utilisant une installation selon une des revendications 1 à 28 **caractérisé en ce que** les cartes imprimées (1) sont nettoyées par ultrasons et/ou plongées dans un bain et/ou par un procédé de vaporisation et/ou par des brosses rotatives,
en ce qu'elle sont éclairées par un système d'éclairage sans réflexion et balayées par un détecteur optique (4)
en ce que le signal de sortie du détecteur optique (4) est utilisé par le système de traitement de l'image pour reconnaître les coordonnées des contours et de préférence le type des composants (12, 14)
et en ce que le dispositif (11, 13) pour retirer les composants (12, 14) retire les composants (12, 14) contenant des substances polluantes et ceux qui sont rentables économiquement de la plaque imprimée (1) tout en étant commandé par le système de traitement de l'image et les place dans des cases qui leur sont attribuées tandis que les brasures (22) de chacun des composants (12, 14) sont chauffées localement.

30. Procédé selon la revendication 29 **caractérisé en ce que** les cartes imprimées (1) après le nettoyage de composants spéciaux, de supports de connexion montés et autres composants ne pouvant pas être retirés automatiquement (12, 14) en sont libérées.

31. Procédé selon la revendication 29 ou 30 **caractérisé en ce que** le fonctionnement de tous les composants retirés qui sont rentables économiquement (12, 14) est vérifié, qu'ils sont nettoyés à nouveau, que leurs contacts sont réparés que les restes de brasage sont retirés et qu'ils sont à nouveau étamés.
